# EUROPEAN PATENT APPLICATION

(11) **EP 2 827 362 A1**
(43) Date of publication of application: **21.01.2015**
(21) Application number: 12871254.4
(22) Date of filing: 12.03.2012
(51) Int. Cl.: H01L 21/301, H01L 21/02, H01L 21/265, H01L 21/268, H01L 21/683

(54) **VACUUM SUCTION STAGE, SEMICONDUCTOR WAFER DICING METHOD, AND SEMICONDUCTOR WAFER ANNEALING METHOD**

(71) Applicant: Mitsubishi Electric Corporation, Tokyo 100-8310 (JP)
(72) Inventor: MATSUMURA Tamio, Tokyo 100-8310 (JP)
(74) Representative: Prüfer & Partner GbR European Patent Attorneys
(86) International application number: PCT/JP2012/056265
(87) International publication number: WO 2013/136411

(57) **Abstract**

The present invention is intended to provide a vacuum suction stage that suppresses damage on a dicing tape during dicing and a method of dicing a semiconductor wafer using the vacuum suction stage. The present invention is further intended to provide a method of annealing a semiconductor wafer using the vacuum suction stage that suppresses bubble formation in a grinding protection tape. The vacuum suction stage of the present invention includes a placement surface 1a on which a semiconductor wafer 6 is to be placed. A vacuum suction hole 2 is formed in the placement surface 1a only in an area external to a chip region 6a of the semiconductor wafer 6.

## Description

### Technical Field

The present invention relates to a stage to vacuum suck a semiconductor wafer, and a dicing method and an annealing method using the stage.

### Background Art

A method of cutting a semiconductor wafer such as an Si semiconductor wafer into chips during semiconductor process includes a blade cutting methods and a laser cutting method. According to one of the laser cutting methods, a semiconductor substrate is cut with a laser beam introduced into a high-pressure water column of a diameter of several tens of micrometers (see patent literature 1). This method advantageously suppresses temperature increase of a cut surface by the use of water and can remove cutting scraps of a process target with a water flow.

### Prior Art Literature

### Patent Literature

Patent Literature 1: Publication of Japanese Patent No. 3680864

### Summary of Invention

### Problems to be Solved by Invention

In the aforementioned method, a semiconductor wafer as a process target is pasted on the center of a dicing tape held by a ring-shaped mount frame and then placed on a semiconductor wafer stage. The semiconductor wafer stage is given a vacuum suction hole of a diameter of several hundreds of micrometers. Then, the semiconductor wafer fixed to the semiconductor wafer stage in this way is cut.

A part of the dicing tape contacting the vacuum suction hole receives force acting to pull this part into the vacuum suction hole. The dicing tape additionally receives the high pressure of the water column having been used for cutting the semiconductor wafer. This causes deformation, even disconnection in some cases, of the dicing tape. Major part of the laser beam passes through the transparent dicing tape at this time, so that the dicing tape is not damaged seriously by the laser.

Deforming the dicing tape so as to push the dicing tape into the vacuum suction hole generates a gap between the back surface of the semiconductor wafer and the dicing tape. This causes a problem in that the back surface of the semiconductor chip is contaminated with scraps generated during the cutting and accumulated in the gap. Further, occurrence of disconnection of the dicing tape disables expansion performed in a later step, causing a problem in that chips cannot be picked up from the dicing tape.

The present invention has been made in view of the aforementioned problems. The present invention is intended to provide a vacuum suction stage that suppresses damage on a dicing tape during dicing and a method of dicing a semiconductor wafer using the vacuum suction stage. The present invention is further intended to provide a method of annealing a semiconductor wafer using the vacuum suction stage that suppresses bubble formation in a grinding protection tape.

### Means of Solving Problems

A vacuum suction stage of the present invention includes a placement surface on which a semiconductor wafer is to be placed. A vacuum suction hole is formed in the placement surface only in an area external to a chip region of the semiconductor wafer. Advantageous Effects of Invention

The vacuum suction stage of the present invention includes the placement surface on which a semiconductor wafer is to be placed. The vacuum suction hole is formed in the placement surface only in an area external to the chip region of the semiconductor wafer. A dicing line and the position of the vacuum suction hole do not overlap when the semiconductor wafer is diced using the vacuum suction stage. This suppresses damage on a dicing tape.

These and other objects, features, aspects and advantages of the present invention will become more apparent from the following detailed description of the present invention when taken in conjunction with the accompanying drawings.

### Brief Description of Drawings

Fig. 1 is a top view of a vacuum suction stage of a first embodiment.
Fig. 2 is a sectional view of the vacuum suction stage of the first embodiment.
Fig. 3 shows how a semiconductor wafer is diced using the vacuum suction stage of the first embodiment.
Fig. 4 is a sectional view of a semiconductor wafer with a partially hollowed out back surface.
Fig. 5 is a sectional view showing a condition where the semiconductor wafer with a partially hollowed out back surface is pasted on a dicing frame.
Fig. 6 is a top view of a vacuum suction stage of a second embodiment.
Fig. 7 is a sectional view of the vacuum suction stage of the second embodiment.
Fig. 8 shows how a semiconductor wafer is diced using the vacuum suction stage of the second embodiment.
Fig. 9 is a top view of a vacuum suction stage of a third embodiment.
Fig. 10 is a sectional view of the vacuum suction stage of the third embodiment.
Fig. 11 shows how a semiconductor wafer is laser annealed using the vacuum suction stage of the third embodiment.

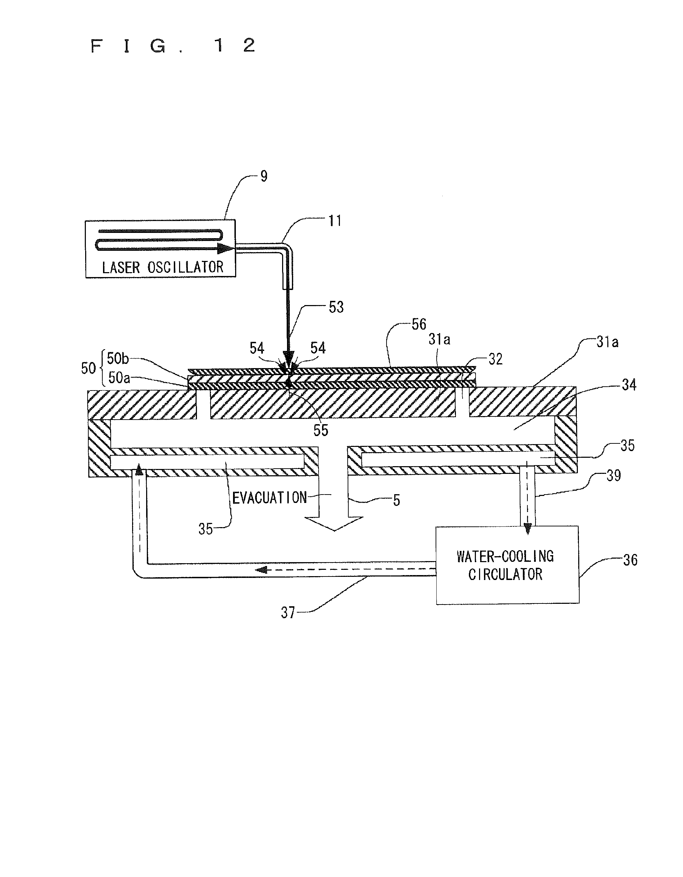

Fig. 12 shows how a semiconductor wafer is laser annealed using the vacuum suction stage of the third embodiment.
Fig. 13 is a top view of a vacuum suction stage of a first prerequisite technique.
Fig. 14 is a sectional view of the vacuum suction stage of the first prerequisite technique.
Fig. 15 is a top view showing a condition where a semiconductor wafer is placed on a dicing frame.
Fig. 16 is a sectional view showing a condition where the semiconductor wafer is placed on the dicing frame.
Fig. 17 is a sectional view showing a condition where the dicing frame is placed on the vacuum suction stage of the first prerequisite technique.
Fig. 18 is a sectional view showing how a semiconductor wafer is diced using the vacuum suction stage of the first prerequisite technique.
Fig. 19 is a sectional view showing how the semiconductor wafer is diced using the vacuum suction stage of the first prerequisite technique.
Fig. 20 is a top view of a vacuum suction stage of a second prerequisite technique.
Fig. 21 is a sectional view of the vacuum suction stage of the second prerequisite technique.
Fig. 22 is a sectional view of a semiconductor wafer with a grinding protection tape sticking to the semiconductor wafer.
Fig. 23 is a sectional view of a semiconductor wafer with the grinding protection tape sticking to the semiconductor wafer.
Fig. 24 is a sectional view of a semiconductor wafer with the grinding protection tape sticking to the semiconductor wafer.
Fig. 25 is a sectional view showing how a semiconductor wafer is laser annealed using the vacuum suction stage of the second prerequisite technique.
Fig. 26 is a sectional view showing how the semiconductor wafer is laser annealed using the vacuum suction stage of the second prerequisite technique. Description of Embodiment(s)

### <A. First Prerequisite Technique>

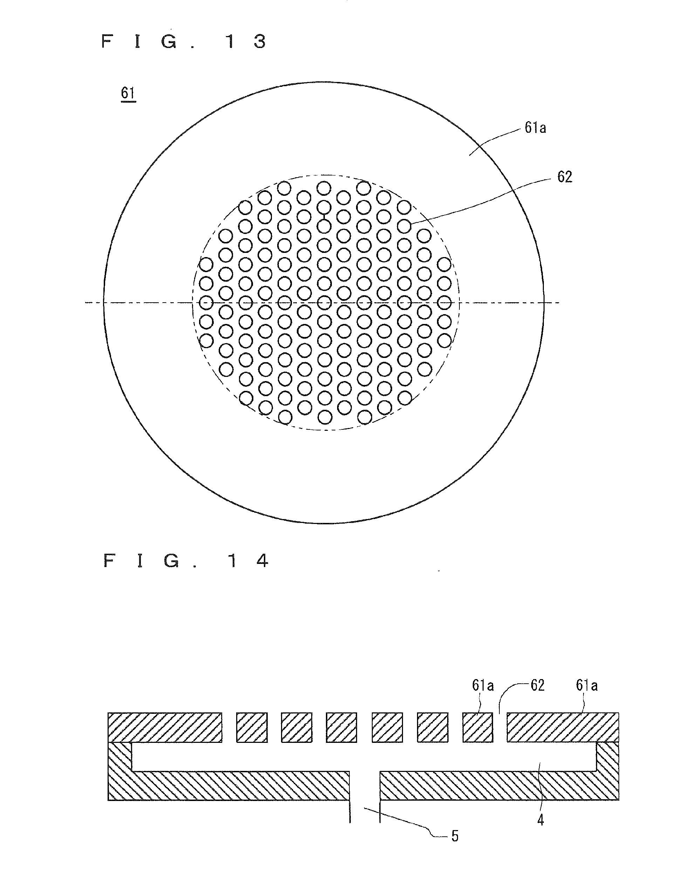

Fig. 13 is a plan view of a vacuum suction stage 61 of a first prerequisite technique of the present invention. Fig. 14 is a sectional view of the vacuum suction stage 61. The vacuum suction stage 61 is made of quartz and has a hollow structure with stage space 4 inside as shown in Fig. 14. The vacuum suction stage 61 has a vacuum exhaust hole 5 formed in the lower surface thereof and a plurality of vacuum suction holes 62 formed in a placement surface 61a thereof. As shown in Fig. 13, the vacuum suction holes 62 are distributed in a pattern concentric with the vacuum suction stage 61.

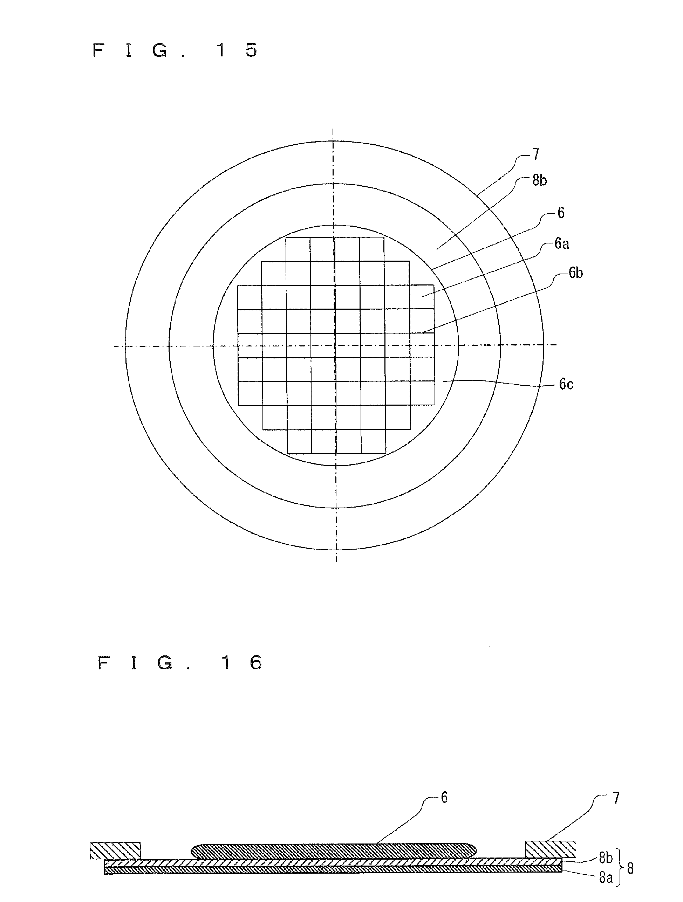

Fig. 15 is a plan view of a dicing frame on which a semiconductor wafer 6 is placed. Fig. 16 is a sectional view of the dicing frame. The dicing frame is composed of an annular mount frame 7 made of SUS and a dicing tape 8 sticking to the mount frame 7. As shown in Fig. 16, the dicing tape 8 has a two-layer structure with a base material 8a and an adhesive material 8b. The adhesive material 8b adhesively contacts the mount frame 7 at opposite ends of the adhesive material 8b. The semiconductor wafer 6 is pasted on the center of the adhesive material 8b.

As shown in Fig. 15, dicing lines 6b are drawn on the semiconductor wafer 6 to define chip regions 6a to be cut out in a dicing step and a peripheral region 6c except the chip regions 6a.

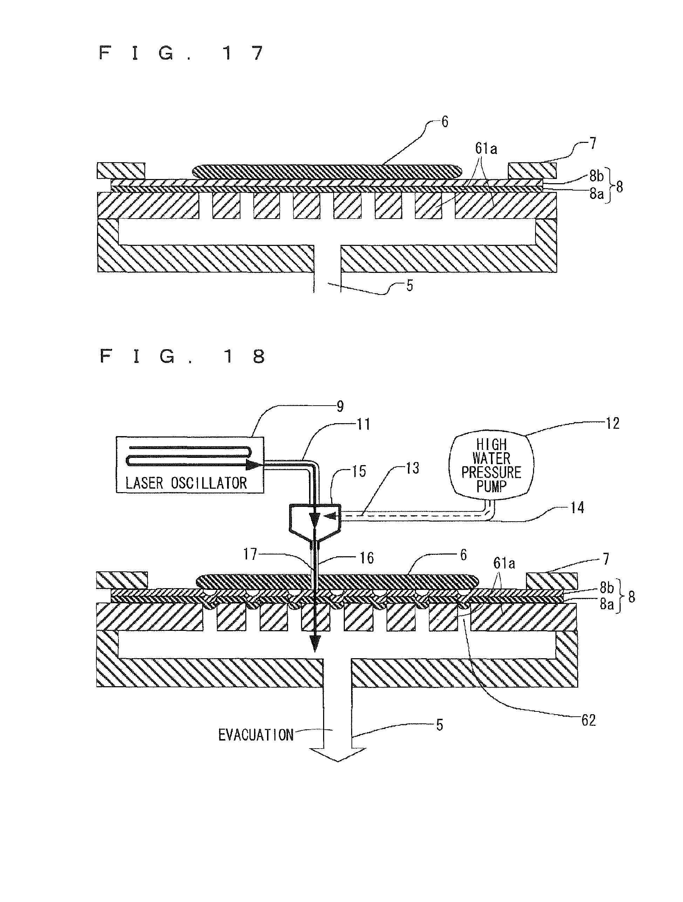

The dicing frame on which the semiconductor wafer 6 is pasted is placed on the vacuum suction stage 61. Fig. 17 is a sectional view showing this condition. As clearly seen from Fig. 17, the vacuum suction holes 62 are positioned below the semiconductor wafer 6 while the dicing tape 8 is placed between the semiconductor wafer 6 and the vacuum suction holes 62. Making evacuation for example with a vacuum pump through the vacuum exhaust hole 5 generates sucking action through the vacuum suction holes 62 to fix the dicing frame on the vacuum suction stage 61.

While the dicing frame is fixed on the vacuum suction stage 61, the semiconductor wafer 6 is diced along the dicing lines 6b (see Fig. 15). Fig. 18 is a sectional view showing this condition and explaining a water get-guided laser that performs dicing by introducing a laser beam into a water column. As shown in Fig. 18, a laser beam output from a laser oscillator 9 passes through an optical fiber 11 to be introduced into a mixture nozzle 15. If the laser beam is the second harmonic of a YAG laser, for example, this laser beam has a wavelength of 532 nm. High-pressure water 13 from a high water pressure pump 12 passes through a high-pressure water pipe 14 to also flow into the mixture nozzle 15. The mixture nozzle 15 is designed such that high-pressure water reduced in diameter to some tens of micrometers is output as a water column 16 from the mixture nozzle 15 and that a laser beam 17 propagates inside the water column 16 while being reflected totally.

The water column 16 is ejected onto the dicing lines 6b of the semiconductor wafer 6. The laser beam 17 cuts the semiconductor wafer 6 by dissolving and then passes through the transparent dicing tape 8 and the placement surface 61a of the vacuum suction stage 61. As shown in Fig. 18, if the placement surface 61a exists below a dicing part, the water column 16 does not pass through the dicing tape 8.

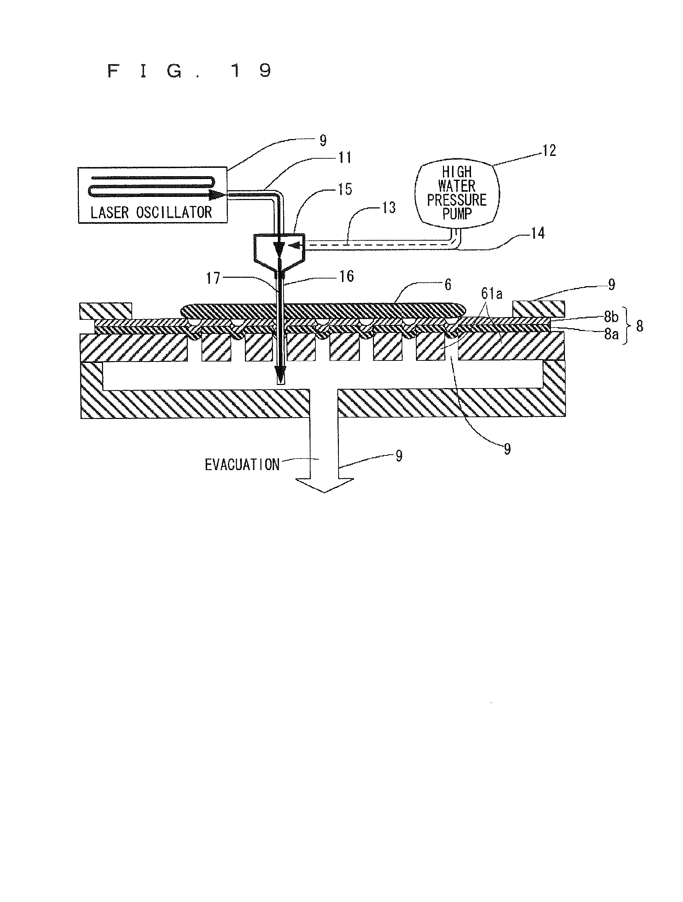

Meanwhile, if the semiconductor wafer 6 is diced at a part directly above the vacuum suction hole 62, the high-pressure water column 16 deforms the dicing tape 8 as the dicing tape 8 does not have a foundation to support this part and by the action of evacuation. This generates a gap between the back surface of the semiconductor wafer 6 and the dicing tape 8. The back surface of a semiconductor chip may be contaminated with scraps generated during cutting the semiconductor wafer and accumulated in this gap. Occurrence of disconnection of the dicing tape 8 resulting from the deformation thereof (see Fig. 19) disables pickup of chips from the dicing tape 8 during expansion performed in a later step.

In view of the aforementioned problems, a vacuum suction stage of a first embodiment has a structure that avoids contact of the high-pressure water column 16 with a vacuum suction hole during dicing, thereby preventing damage on a dicing tape.

### <B. First Embodiment>

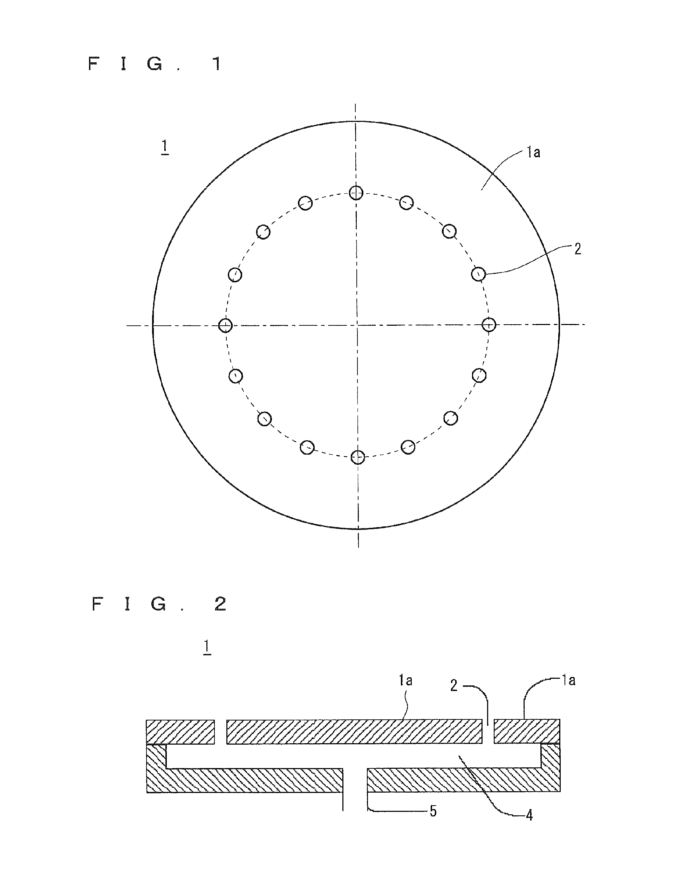

Fig. 1 is a plan view of a vacuum suction stage 1 of the first embodiment. Fig. 2 is a sectional view of the vacuum suction stage 1. The vacuum suction stage 1 is made of quartz and has a hollow structure with the stage space 4 inside as shown in Fig. 2. The vacuum suction stage 1 has the vacuum exhaust hole 5 formed in the lower surface thereof and the plurality of vacuum suction holes 2 formed in the upper surface thereof functioning as a placement surface. As shown in Fig. 1, the vacuum suction holes 2 are formed in an annular pattern along the outer circumference of the vacuum suction stage 1.

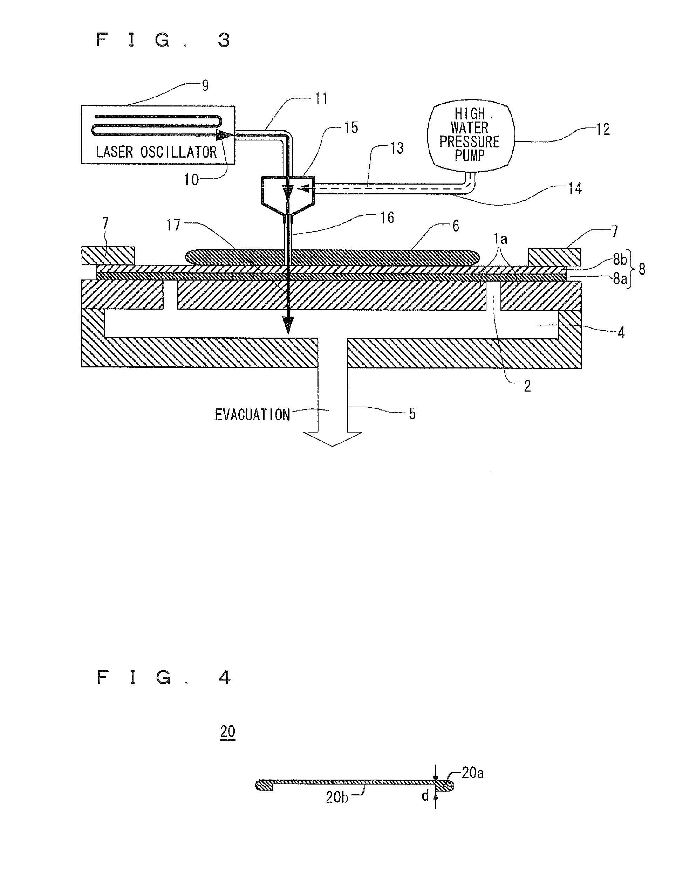

Fig. 3 shows how the semiconductor wafer 6 is diced using the vacuum suction stage 1. A dicing frame on which the semiconductor wafer 6 is pasted is placed on the vacuum suction stage 1 and then the semiconductor wafer 6 is diced. The dicing frame has the same structure as that of the first prerequisite technique, so that it will not be described again. Dicing means (laser oscillator 9, high water pressure pump 12, mixture nozzle 15) is the same as that of the first prerequisite technique, so that it will not be described again.

As shown in Fig. 3, the vacuum suction holes 2 are formed externally to an area where the semiconductor wafer 6 is placed. Thus, the water column 16 will not be ejected onto a part of the dicing tape 8 directly above the vacuum suction hole 2 during dicing. The vacuum suction holes 2 of Fig. 3 are formed at positions not overlapping the semiconductor wafer 6. Meanwhile, the vacuum suction hole 2 is required only to be formed externally to the chip regions 6a (see Fig. 15) of the semiconductor wafer 6, so that it can be formed below the peripheral region 6c (see Fig. 15) of the semiconductor wafer 6.

### <B-1. Advantageous Effects>

The vacuum suction stage 1 of the first embodiment has a placement surface 1a on which the semiconductor wafer 6 is to be placed. The vacuum suction holes 2 are formed in the placement surface 1a only in an area external to the chip regions 6a of the semiconductor wafer 6. A dicing line on the semiconductor wafer 6 and the vacuum suction holes 2 do not overlap when the semiconductor wafer 6 is placed on the vacuum suction stage 1. Thus, deformation or disconnection of the dicing tape 8 to be caused by a high-pressure water column is suppressed during dicing through a water get-guided laser. This solves problems such as contamination of the back surface of a chip and disabling expansion of the dicing tape 8 that leads to disabling pickup of a chip.

A method of dicing a semiconductor wafer using the vacuum suction stage 1 of the first embodiment includes: (a) a step of placing the semiconductor wafer 6 with the dicing tape 8 sticking to the semiconductor wafer 6 on the vacuum suction stage 1 while the dicing tape 8 is pointed downward; and (b) dicing the semiconductor wafer 6 through a water get-guided laser into chips. The step (b) is performed after the step (a). In the step (b), a high-pressure water column is ejected onto a position away from the vacuum suction holes 2. Thus, deformation or disconnection of the dicing tape 8 to be caused by the high-pressure water column is suppressed. This solves problems such as contamination of the back surface of a chip and disabling expansion of the dicing tape 8 that leads to disabling pickup of a chip.

### <C. Second Embodiment>

A vacuum suction stage of a second embodiment is one on which a semiconductor wafer of a shape with a partially hollowed out back surface is to be placed.

Fig. 4 is a sectional view of a semiconductor wafer 20 of this shape. The semiconductor wafer 20 is given a step d between the hollowed out part and an outer circumferential ring part 20a.

The following explains reason for hollowing out a semiconductor wafer. As an example, process of forming an IGBT includes a step of forming an emitter and a gate on a front side of a semiconductor wafer, a subsequent step of grinding the semiconductor wafer from its back surface to thin the semiconductor wafer, and a step of forming a collector by implanting ions into the back surface, laser annealing the back surface, or depositing a film by sputtering on the back surface. If an eight-inch semiconductor wafer is ground entirely to be thinned to a thickness of 100 µm or less, warpage of 5 mm or more is generated in the semiconductor wafer so that the semiconductor wafer cannot be carried to an ion implantation machine or a sputtering device, for example. A method of grinding only a central part of a semiconductor wafer (back grinding) has been developed to prevent such warpage. A ring part of from 2 to 4 mm along the outer circumference of a semiconductor wafer remains unremoved to reinforce an internal thin part, thereby suppressing warpage.

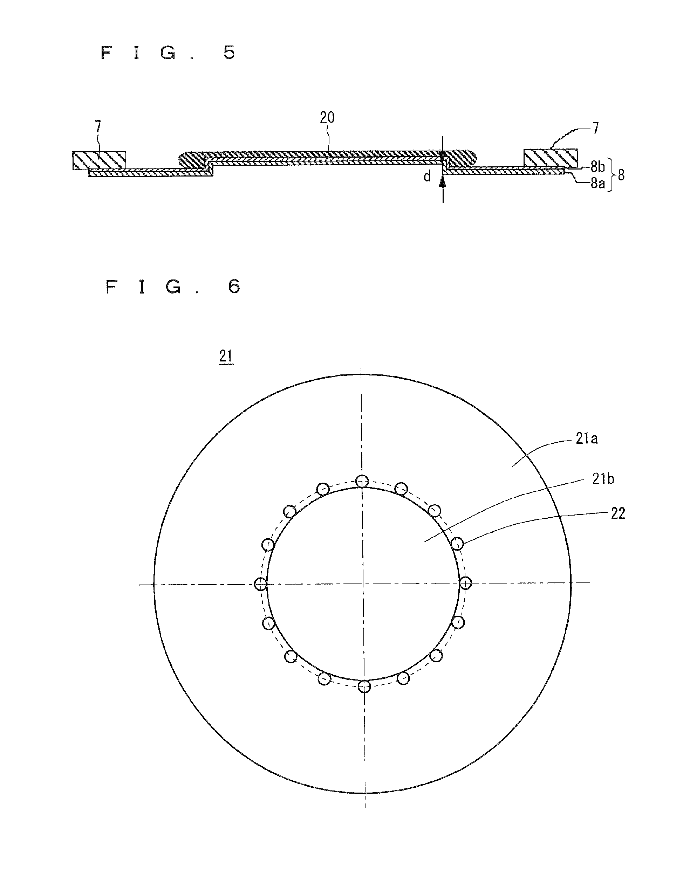

Fig. 5 is a sectional view showing a condition where the semiconductor wafer 20 is pasted on a dicing frame. The dicing frame has the same structure as that of the first embodiment, so that it will not be described again. The dicing tape 8 is attached to the back surface of the semiconductor wafer 20 to form the step d in conformity with the shape of the semiconductor wafer 20.

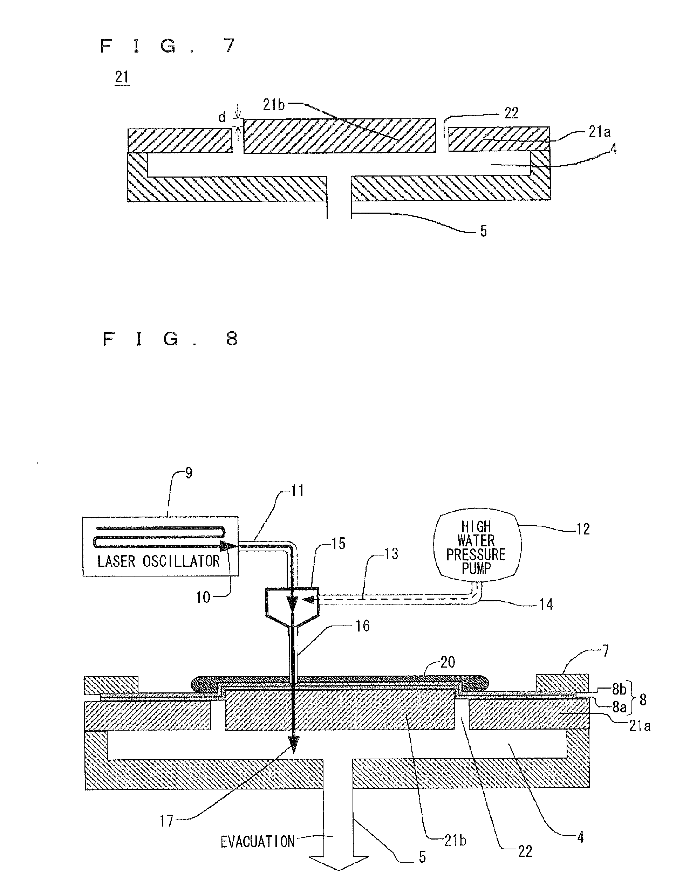

Fig. 6 is a top view of a vacuum suction stage 21 of the second embodiment on which the semiconductor wafer 20 is to be placed. Fig. 7 is a sectional view of the vacuum suction stage 21. A placement surface of the vacuum suction stage 21 is separated into a placement surface outer part 21a and a placement surface inner part 21b. Vacuum suction holes 22 are distributed in an annular pattern along a boundary between the placement surface outer and inner parts 21a and 21 b. As shown in Fig. 7, the placement surface inner part 21b is formed to a thickness greater by a height d than the placement surface outer part 21a so that it projects by the height d. The height d of the projection corresponds to the aforementioned step d of the semiconductor wafer 20.

Fig. 8 shows how the semiconductor wafer 20 is diced while the dicing frame on which the semiconductor wafer 20 is pasted is placed on the vacuum suction stage 21. Dicing means (laser oscillator 9, high water pressure pump 12, mixture nozzle 15) is the same as that of the first prerequisite technique, so that it will not be described again. The vacuum suction stage 21 cancels out the step of the semiconductor wafer 20 so the dicing tape 8 tightly contacts the placement surface outer and inner parts 21a and 21b.

In this condition, the vacuum suction holes 22 are positioned near the ring part 20a of the semiconductor wafer 20. Accordingly, the high-pressure water column 16 will not be ejected onto a part of the dicing tape 8 directly above the vacuum suction hole 22 during dicing. Thus, like in the first embodiment, damage on the dicing tape 8 can be prevented. This solves problems such as contamination of the back surface of a chip and disabling expansion of the dicing tape 8 that leads to disabling pickup of a chip.

### <C-1. Advantageous Effects>

The placement surface of the vacuum suction stage 21 of the second embodiment on which the semiconductor wafer 20 is to be placed includes the placement surface outer part 21a (first region) in which the vacuum suction holes 22 are formed and the placement surface inner part 21b (second region) surrounded by the placement surface outer part 21a and projecting like a step from the placement surface outer part 21a. The placement surface has a step formed by the placement surface outer and inner parts 21a a and 21b and corresponding to the hollowed out shape of the semiconductor wafer 20, so that it can be used for dicing of the semiconductor wafer 20. A chip region of the semiconductor wafer 20 is positioned above the placement surface inner part 21b to prevent overlap of the vacuum suction holes 22 in the placement surface outer part 21a with a dicing line. Thus, deformation or disconnection of the dicing tape 8 to be caused by a high-pressure water column is suppressed during dicing through a water get-guided laser. This solves problems such as contamination of the back surface of a chip and disabling expansion of the dicing tape 8 that leads to disabling pickup of a chip.

A method of dicing a semiconductor wafer of the second embodiment using the vacuum suction stage 21 includes: (a) a step of placing the semiconductor wafer 20 with the dicing tape 8 sticking to the lower surface of the semiconductor wafer 20 on the vacuum suction stage 21 while the dicing tape 8 is pointed downward, the lower surface having a shape corresponding to a step of the placement surfaces 21a and 21b of the vacuum suction stage 21, the semiconductor wafer 20 being placed so as to conform to the step of the placement surfaces 21a and 21b; and (b) dicing the semiconductor wafer 20 through a water get-guided laser. The step (b) is performed after the step (a). The step of the placement surface of the vacuum suction stage 21 corresponds to the shape of the lower surface of the semiconductor wafer 20, so that the semiconductor wafer 20 can be diced while kept in a horizontal posture. A chip region of the semiconductor wafer 20 is positioned above the placement surface inner part 21b to prevent overlap of the vacuum suction holes 22 in the placement surface outer part 21a with a dicing line. Thus, deformation or disconnection of the dicing tape 8 to be caused by a high-pressure water column is suppressed during dicing through a water get-guided laser. This solves problems such as contamination of the back surface of a chip and disabling expansion of the dicing tape 8 that leads to disabling pickup of a chip.

### <D. Second Prerequisite Technique>

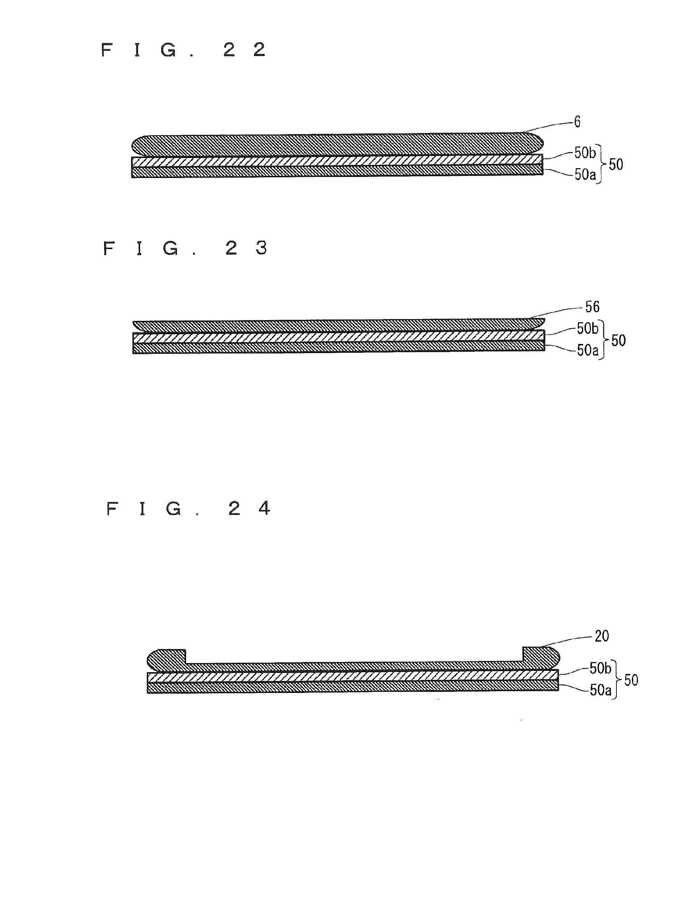

During manufacturing steps of a semiconductor device, after a semiconductor wafer is subjected to device process such as circuit formation, a grinding protection tape is attached to the front surface (first main surface) of the semiconductor wafer and then the back surface (second main surface, lower surface) of the semiconductor wafer is ground, thereby thinning the semiconductor wafer. Fig. 22 is a sectional view of the semiconductor wafer 6 with a grinding protection tape 50 sticking to the semiconductor wafer 6. The grinding protection tape 50 has a two-layer structure with a base material 50a and an adhesive material 50b for sticking to the semiconductor wafer 6.

Figs. 23 and 24 are sectional views each showing a semiconductor wafer after being subjected to back grinding. Fig. 23 shows a semiconductor wafer 56 with an entirely ground back surface. Fig. 24 shows the semiconductor wafer 20 of the second embodiment that is hollowed out while the outer circumferential ring part 20a remains unremoved.

A vacuum suction stage of a second prerequisite technique of the present invention is to fix a semiconductor wafer with the grinding protection tape 50 sticking to the semiconductor wafer during laser annealing of the semiconductor wafer after the semiconductor wafer is subjected to the back grinding shown in Fig. 23 or 24. Laser annealing is intended to activate ion species implanted into the semiconductor wafer through the back surface thereof during device processing.

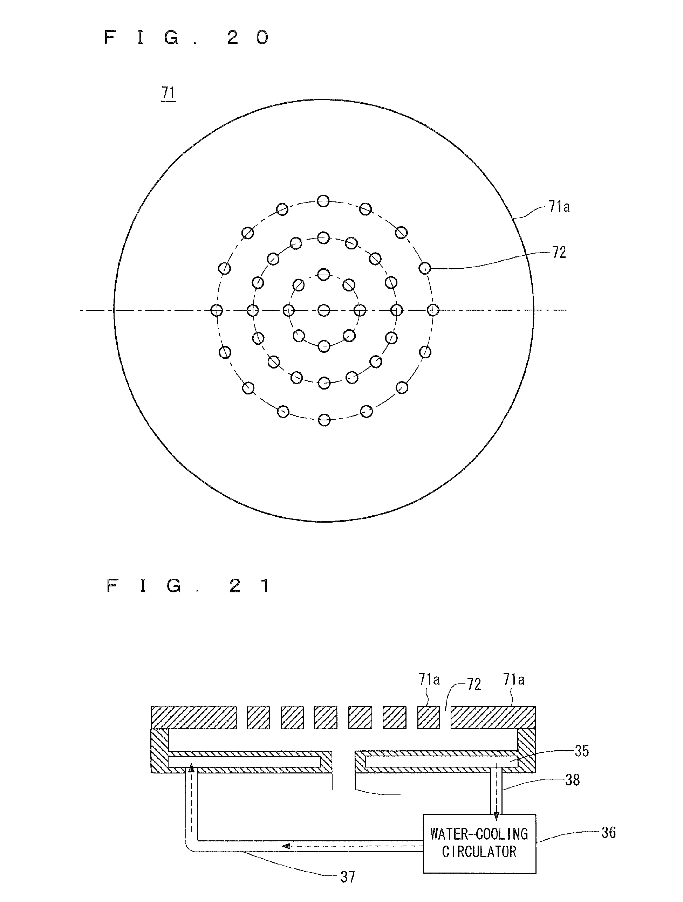

Fig. 20 is a top view of a vacuum suction stage 71 of the second prerequisite technique. Fig. 21 is a sectional view of the vacuum suction stage 71. A placement surface 71a of the vacuum suction stage 71 is given a plurality of vacuum suction holes 72. As shown in Fig. 20, the vacuum suction holes 72 are formed along circumferences of a plurality of concentric circles.

As shown in Fig. 21, the vacuum suction stage 71 includes the stage space 4 for evacuation and additionally, an internal flow path 35 for cooling water. The internal flow path 35 connects to a water-cooling circulator 36 through a pipe 37 and a pipe 38. Cooling water fed from the water-cooling circulator 36 passes through the pipe 37 to flow into the internal flow path 35, thereby cooling the vacuum suction stage 71. Then, the cooling water passes through the pipe 38 to flow back into the water-cooling circulator 36.

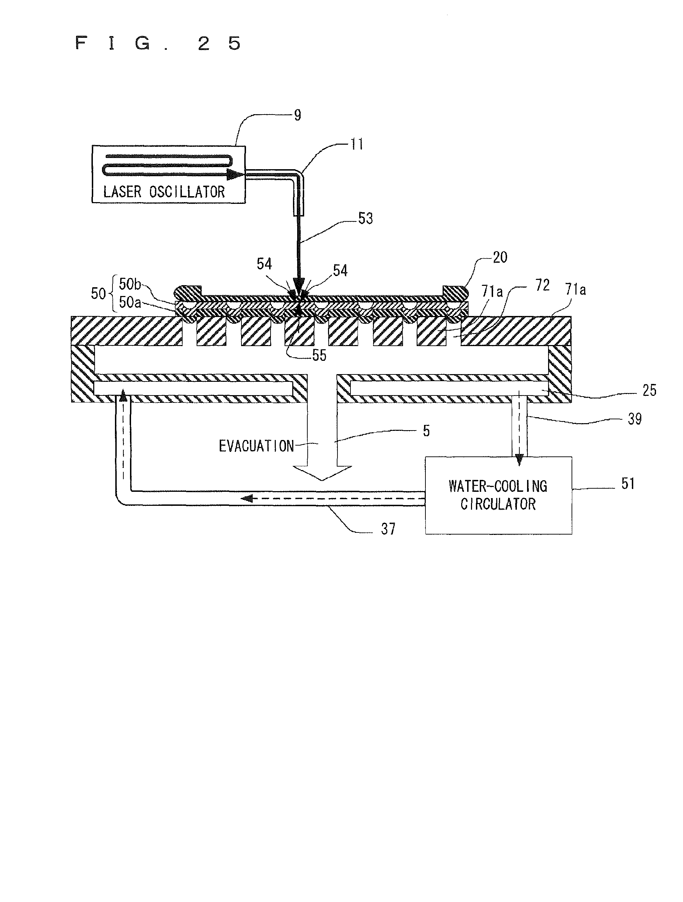

Fig. 25 shows how the back surface of the semiconductor wafer 20 is subjected to laser annealing process while the semiconductor wafer 20 with the grinding protection tape 50 sticking to the semiconductor wafer 20 is placed on the vacuum suction stage 71. A laser beam 53 output from the laser oscillator 9 passes through an optical fiber 52 to be applied to a hollowed out surface 20b of the semiconductor wafer 20.

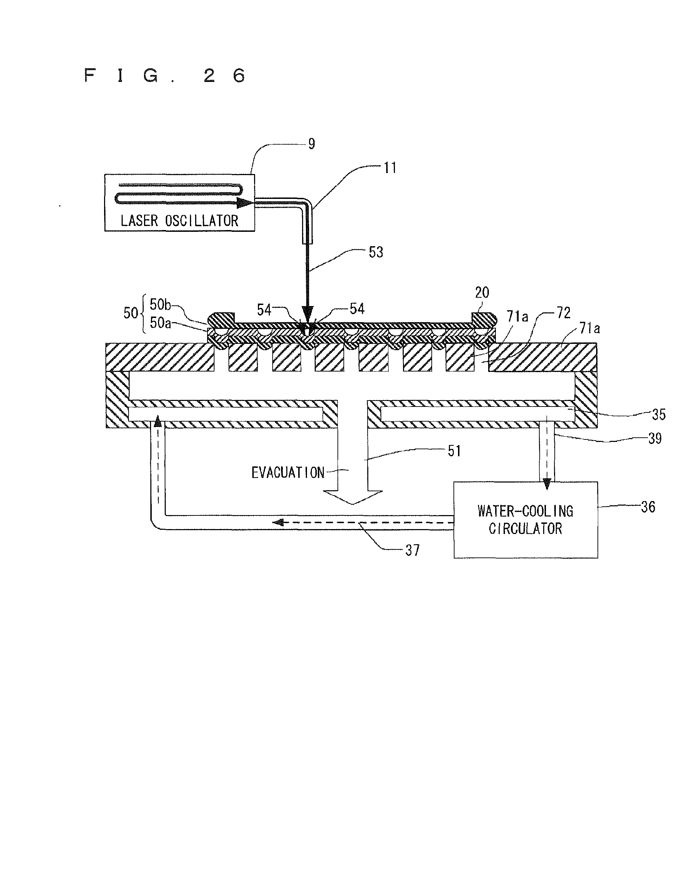

The semiconductor wafer 20 is thinned in the back grinding step. Accordingly, if the heat of the laser beam 53 is transferred to the grinding protection tape 50 protecting the front surface of the semiconductor wafer 20 to form bubbles in the grinding protection tape 50, the following problem may occur: the semiconductor wafer 20 cannot be carried in preparation for a next step; or the tape cannot be removed successfully. In order to avoid these problems, the water-cooling circulator 36 cools the vacuum suction stage 71 as shown in Fig. 25. Thus, heat 54 resulting from the laser beam is cooled with a cooling flow 55 transferred from the stage, thereby preventing bubble formation in the tape 50. However, if the laser beam 53 is applied from directly above the vacuum suction hole 72 as shown in Fig. 26, the cooling flow 55 does not reach a part of the grinding protection tape 50 irradiated with the laser beam. This acts, together with vacuum suction, to make bubble formation more likely in the grinding protection tape 50.

In view of the aforementioned problems, a vacuum suction stage of a third embodiment has a structure that avoids application of a laser beam to a vacuum suction hole during laser annealing performed after back grinding, thereby preventing damage on the grinding protection tape 50.

### <E. Third Embodiment>

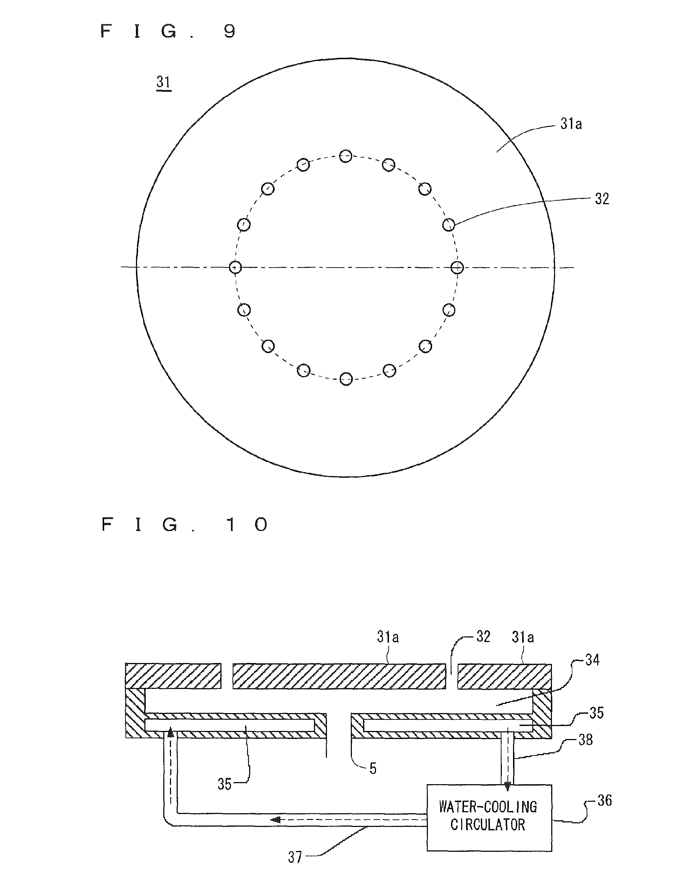

Fig. 9 is a top view of a vacuum suction stage 31 of a third embodiment. Fig. 10 is a sectional view of the vacuum suction stage 31. As shown in Fig. 9, vacuum suction holes 32 are formed in an annular pattern in a placement surface 31a of the vacuum suction stage 31. More specifically, the vacuum suction holes 32 are designed so as to be positioned only along the outer circumference of a chip region of a semiconductor wafer when the semiconductor wafer is placed on the placement surface 31 a. A cooling structure for the vacuum suction stage 31 including the water-cooling circulator 36 is the same as that of the second prerequisite technique, so that it will not be described again.

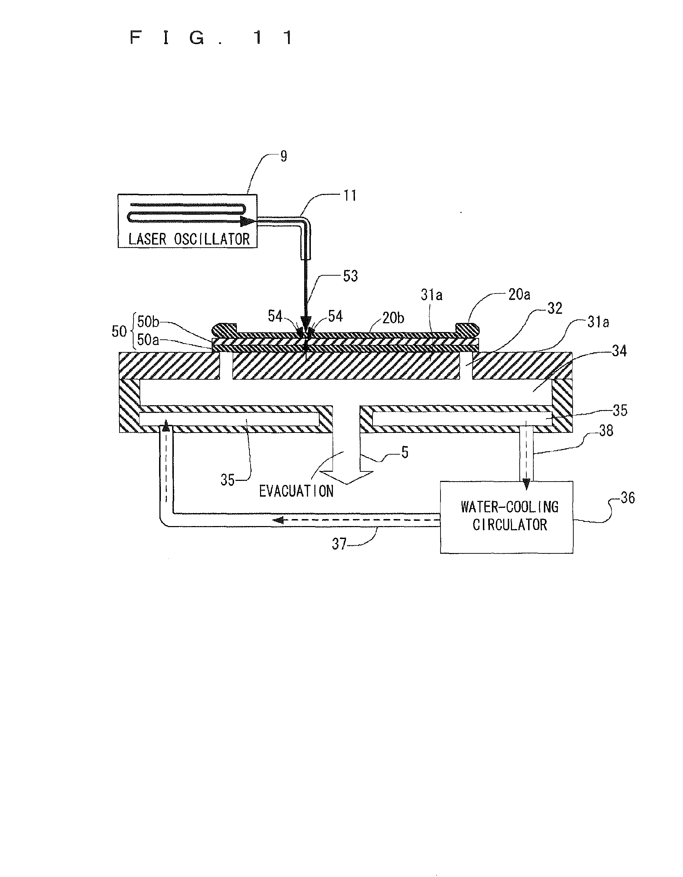

Fig 11 shows how a second main surface of the semiconductor wafer 20 is subjected to laser annealing process while the semiconductor wafer 20 with the grinding protection tape 50 sticking to a first main surface of the semiconductor wafer 20 is placed on the vacuum suction stage 31 and the grinding protection tape 50 is pointed downward. In Fig. 11, constituting elements same as those of the second prerequisite technique are identified by the same reference signs.

The vacuum suction holes 32 are positioned below a region of the semiconductor wafer 20 not to be irradiated with a laser beam. Thus, the heat 54 of the laser beam 53 is always cooled with the cooling flow 55 during a laser annealing step, making it possible to suppress bubble formation in the grinding protection tape 50.

Fig. 11 shows the laser annealing process on the semiconductor wafer 20. The same effect is also achieved during laser annealing process performed on the entirely thinned semiconductor wafer 56 placed on the suction semiconductor wafer 31.

### <E-1. Advantageous Effects>

A method of annealing a semiconductor wafer using the vacuum suction stage 31 of the third embodiment includes: (a) a step of attaching the grinding protection tape 50 to a first main surface of the semiconductor wafer 20 or 56 and then grinding a second main surface opposite the first main surface; (b) placing the semiconductor wafer 20 or 56 on the vacuum suction stage 31 while the grinding protection tape 50 is pointed downward, the step (b) being performed after the step (a); and (c) a step of laser annealing the second main surface of the semiconductor wafer 20 or 56, the step (c) being performed after the step (b). In the vacuum suction stage 31, the vacuum suction holes 32 are formed externally to a chip region of the semiconductor wafer 20 or 56 to be irradiated with a laser. Thus, the vacuum suction holes 22 do not interfere with cooling of the grinding protection tape 50, thereby suppressing bubble formation in the grinding protection tape 50.

### While the invention has been shown and described in detail, the foregoing description is in all aspects illustrative and not restrictive and is not intended to limit the invention. It is therefore understood that numerous modifications and variations can be devised without departing from the scope of the invention.

### Reference Signs List

- 1, 21, 31: Vacuum suction stage
- 1a, 31a: Placement surface
- 2, 22, 32: Vacuum suction hole
- 4, 34: Stage space
- 5: Vacuum exhaust hole
- 6, 20, 56: Semiconductor wafer
- 7: Mount frame
- 8: Dicing tape
- 8a: Base material
- 8b: Adhesive material
- 9: Laser oscillator
- 10, 17, 53: Laser beam
- 11: Optical fiber
- 12: High water pressure pump
- 13: High-pressure water
- 14: High-pressure water pipe
- 15: Mixture nozzle
- 16: Water column
- 20b: Hollowed out surface
- 21a: Placement surface outer part
- 21b: Placement surface inner part
- 35: Internal flow path
- 36: Water-cooling circulator
- 37, 38: Pipe

## Claims

1. A vacuum suction stage (1, 21, 31) comprising a placement surface (1a, 21 a, 21 b, 31a) on which a semiconductor wafer (6, 20, 56) is to be placed,
wherein a vacuum suction hole (2, 22, 32) is formed in said placement surface (1a, 21a, 21b, 31a) only in an area external to a chip region (6a) of said semiconductor wafer (6, 20, 56).

2. A vacuum suction stage (21) comprising a placement surface (21 a, 21b) on which a semiconductor wafer (20) is to be placed,
wherein said placement surface (21 a, 21b) includes:
a first region (21 a) in which said vacuum suction hole (22) is formed; and
a second region (21 b) surrounded by said first region (21a) and projecting like a step from said first region (21 a).

3. A method of dicing a semiconductor wafer using the vacuum suction stage (1, 21) as recited in claim 1, comprising:
(a) a step of placing a semiconductor wafer (6, 20) with a dicing tape (8) sticking to said semiconductor wafer (6, 20) on said vacuum suction stage (1, 21) while said dicing tape (8) is pointed downward; and
(b) a step of dicing said semiconductor wafer (6, 20) through a water get-guided laser into chips, said step (b) being performed after said step (a).

4. A method of dicing a semiconductor wafer using the vacuum suction stage (21) as recited in claim 2, comprising:
(a) a step of placing a semiconductor wafer (20) with a dicing tape (8) sticking to a lower surface of said semiconductor wafer (20) on said vacuum suction stage (21) while said dicing tape (8) is pointed downward, said lower surface having a shape corresponding to a step of said placement surface (21a, 21b) of said vacuum suction stage (21), said semiconductor wafer (20) being placed so as to conform to said step; and
(b) a step of dicing said semiconductor wafer (20) through a water get-guided laser, said step (b) being performed after said step (a).

5. A method of annealing a semiconductor wafer using the vacuum suction stage (31) as recited in claim 1, comprising:
(a) a step of attaching a grinding protection tape (50) to a first main surface of a semiconductor wafer (20, 56) and then grinding a second main surface opposite said first main surface;
(b) a step of placing said semiconductor wafer (20, 56) on said vacuum suction stage (31) while said grinding protection tape (50) is pointed downward, said step (b) being performed after said step (a); and
(c) a step of laser annealing said second main surface of said semiconductor wafer (20, 56), said step (c) being performed after said step (b).

## Amended claims

### Amended claims under Art. 19.1 PCT

**2.** A vacuum suction stage (21) comprising a placement surface (21 a, 21b) on which a semiconductor wafer (20) is to be placed,
wherein said placement surface (21a, 21b) includes:
a first region (21a) in which a vacuum suction hole (22) is formed; and
a second region (21b) surrounded by said first region (21a) and projecting like a step from said first region (21 a).

**3.** A method of dicing a semiconductor wafer using a vacuum suction stage (1, 21), 31) including a placement surface (1a, 21a, 21b, 31a) on which a semiconductor wafer (6, 20, 56) is to be placed, a vacuum suction hole (2, 22, 32) being formed in said placement surface (1a, 21a, 21b, 31a) only in an area external to a chip region (6a) of said semiconductor wafer (6, 20, 56),
the method comprising:
(a) a step of placing said semiconductor wafer (6, 20) with a dicing tape (8) sticking to said semiconductor wafer (6, 20) on said vacuum suction stage (1, 21) while said dicing tape (8) is pointed downward; and
(b) a step of dicing said semiconductor wafer (6, 20) through a water get-guided laser into chips, said step (b) being performed after said step (a).

**4.** A method of dicing a semiconductor wafer using the vacuum suction stage (21) as recited in claim 2, comprising:
(a) a step of placing a semiconductor wafer (20) with a dicing tape (8) sticking to a lower surface of said semiconductor wafer (20) on said vacuum suction stage (21) while said dicing tape (8) is pointed downward, said lower surface having a shape corresponding to a step of said placement surface (21a, 21b) of said vacuum suction stage (21), said semiconductor wafer (20) being placed so as to conform to said step; and
(b) a step of dicing said semiconductor wafer (20) through a water get-guided laser, said step (b) being performed after said step (a).

**5.** A method of annealing a semiconductor wafer using a vacuum suction stage (1, 21, 31) including placement surface (1a, 21a, 21b, 31a) on which a semiconductor wafer (6, 20, 56) is to be placed, a vacuum suction hole (2, 22, 32) being formed in said placement surface (1a, 21a, 21b, 31a) only in an area external to a chip region (6a) of said semiconductor wafer (6, 20, 56),
the method comprising:
(a) a step of attaching a grinding protection tape (50) to a first main surface of said semiconductor wafer (20, 56) and then grinding a second main surface opposite said first main surface;
(b) a step of placing said semiconductor wafer (20, 56) on said vacuum suction stage (31) while said grinding protection tape (50) is pointed downward, said step (b) being performed after said step (a); and
(c) a step of laser annealing said second main surface of said semiconductor wafer (20, 56), said step (c) being performed after said step (b).
